# EUROPÄISCHE PATENTANMELDUNG

(11) **EP 1 245 361 A1**
(43) Veröffentlichungstag der Anmeldung: **02.10.2002**
(21) Anmeldenummer: 01810305.1
(22) Anmeldetag: 26.03.2001
(51) Int. Cl.: B29C 45/16, H05K 3/10, H05K 1/09, H01C 7/02

(54) **Verfahren zum Spritzgiessen von Formteilen mit elektrischer Leitungsfunktion und elektrisches Bauelement mit einem solchen Formteil**

(71) Anmelder: ABB RESEARCH LTD., 8050 Zürich (CH)
(72) Erfinder: Glatz-Reichenbach, Joachin, 5400 Baden (CH)
(74) Vertreter: ABB Patent Attorneys

(57) **Zusammenfassung**

Die Erfindung bezieht sich auf ein neues Herstellungsverfahren für Formteile aus Polymerwerkstoffen, in denen eine elektrische Leitungsfunktion realisiert sein soll. Ein Anwendungsbeispiel sind Gehäuseteile oder Halterungen für elektrische Geräte, wobei die Gehäuseteile oder Halterungen integrierte elektrische Anschlüsse und Leiterbahnen beinhalten. Erfindungsgemäß wird dabei ein Mehrkomponentenspritzgußverfahren verwendet, bei dem zumindest einer der beteiligten Polymerwerkstoffe (1) eine mit einem metallisch leitfähigen Füllstoff gefüllte Polymermatrix aufweist und damit elektrisch leitfähig ist, wohingegen zumindest ein weiterer Polymerwerkstoff (2) elektrisch isolierend ist.

## Beschreibung

### Technisches Gebiet

Diese Erfindung bezieht sich auf ein Herstellungsverfahren für Formteile, die eine elektrische Leitungsfunktion ausüben sollen. Zum Beispiel kann es sich dabei um Gehäuseteile, Halterungsteile o.ä. handeln, die neben einer ersten Funktion, eben als Gehäuseteil, Halterungsteil oder dergleichen, außerdem eine weitere Funktion erfüllen müssen, zu der in bestimmter Weise die Leitung elektrischen Stroms gehört. Beispielsweise kann es sich dabei um Gehäuseteile mit integrierten elektrischen Anschlüssen und Weiterführung von Strompfaden von diesen Anschlüssen zu anderen Anschlüssen handeln. Solche Formteile sind insbesondere auch unter dem Schlagwort 3D-MID (three-dimensional moulded interconnected devices) bekannt geworden.

### Stand der Technik

Bekannte Herstellungsverfahren für 3D-MID-Formteile beinhalten das Heißprägen von Leiterbahnen auf Formteilen, die Photostrukturierung und Laserablation, das Folienhinterspritzen, katalytische Verfahren, Siebdruck u.a. Bekannt ist insbesondere auch der sog. Zweikomponentenspritzguß, bei dem Formteile aus zumindest zwei Polymerwerkstoffen spritzgegossen werden. Im Zusammenhang mit 3D-MID-Formteilen ist dabei auch versucht worden, durch geeignete Wahl dieser Polymerwerkstoffe bereits durch die Formgebung der beiden Komponenten eine Vorstrukturierung für später aufzubringende Leiterbahnen vorzugeben. Dazu mußten Kombinationen von Polymerwerkstoffen eingesetzt werden, die einerseits spritzgußtauglich sind, zum zweiten eine ausreichende Haftung aneinander aufweisen und zum dritten im Hinblick auf ein Metallisierungsverfahren eine gute Selektivität zeigen. Nach der Herstellung des eigentlichen Formteils soll nämlich die Tatsache ausgenutzt werden, daß der eine der beiden Polymerwerkstoffe mit einem bestimmten Verfahren metallisierbar ist, der andere hingegen nicht. Dadurch soll bei einem an sich unstrukturierten Metallisierungsvorgang die entstehende Metallschicht die Verteilung des metallisierbaren Polymerwerkstoffs wiederspiegeln.

Aus diesen Anforderungen ergeben sich große Restriktionen hinsichtlich der Wahl der Werkstoffe. Im übrigen sind immer wieder Haftungsprobleme aufgetreten, und zwar sowohl zwischen verschiedenen Polymerwerkstoffen als auch zwischen den Polymerwerkstoffen und den Metallschichten.

Diese Probleme lassen sich mit verschiedenen zusätzlichen Techniken verbessern. So können zwischen den Polymerwerkstoffen und den Metallen haftvermittelnde Schichten bzw. Klebstoffe eingesetzt werden oder zusätzliche Strukturierungsschritte erfolgen (wodurch sich die wesentlichen Vorteile des Zweikomponentenspritzgußverfahrens jedoch erübrigen).

### Darstellung der Erfindung

Dieser Erfindung liegt das technische Problem zugrunde, ein verbessertes Herstellungsverfahren für Formteile mit einer elektrischen Leitungsfunktion anzugeben.

Die Erfindung richtet sich auf ein Verfahren zur Herstellung von Formteilen, die eine elektrische Leitungsfunktion aufweisen, bei dem das Formteil mit zumindest zwei Polymerwerkstoffen spritzgegossen wird, dadurch gekennzeichnet, daß zumindest einer der Polymerwerkstoffe eine Polymermatrix und einen metallisch leitfähigen Füllstoff aufweist und durch diesen elektrisch leitfähig ist und zumindest ein weiterer der Polymerwerkstoffe elektrisch isolierend ist.

Daneben richtet sich die Erfindung auch auf ein elektrisches Bauelement, daß ein solchermaßen hergestelltes Formteil enthält oder aus diesem besteht. Ein weiterer Aspekt der Erfindung beschäftigt sich schließlich mit einer vorteilhaften Verwendung eines solchen elektrischen Bauelements.

Bevorzugte Ausführungsformen sind in den abhängigen Ansprüchen angegeben.

Die Grundidee der Erfindung besteht darin, bei einem Mehrkomponentenspritzgußverfahren bei zumindest einem der zumindest zwei beteiligten Polymerwerkstoffe einen metallisch leitfähigen Füllstoff zuzusetzen, so daß dieser Polymerwerkstoff elektrisch leitfähig wird. Der Polymerwerkstoff weist dann also eine Polymermatrix und in dieser Matrix verteilte Füllstoffpartikel auf.

Zumindest ein weiterer Polymerwerkstoff soll im Vergleich dazu elektrisch isolierend sein, also einen sehr viel höheren spezifischen Widerstand aufweisen, so daß durch die Strukturierungsmöglichkeiten der Mehrkomponentenspritzgußtechnik für die elektrisch leitfähigen Teile des Formteils eine bestimmte Geometrie vorgegeben werden kann und andere Teile isolierend bleiben. Damit können beispielsweise Anschlußelemente, Leiterbahnen oder andere Strukturen hergestellt werden, deren Funktion eine elektrische Leitfähigkeit voraussetzt. Natürlich können auch noch weitere Komponenten in dem Spritzgußverfahren beteiligt sein. Dies kann aus geometrischen Gründen geschehen, wobei sich die dabei verwendeten Werkstoffe nicht auf die bereits beschriebenen beschränken. Es können natürlich auch weitere Polymerwerkstoffe hinzugenommen werden, die beliebige elektrische Eigenschaften haben können.

Der wesentliche Vorteil der Erfindung besteht darin, daß die aus dem elektrisch leitfähigen Polymerwerkstoff hergestellten Teile des Formteils bereits intrinsisch leitfähig sind und nicht durch weitere aufwendige Technologieschritte leitfähige Strukturen erzeugt werden müssen. Damit lassen sich Haftungsprobleme zwischen den konventionell notwendigen Metallschichten und den Polymersubstraten gänzlich vermeiden. Es ist damit jedoch nicht ausgeschlossen, auf erfindungsgemäßen Formteilen dennoch Metallschichten anzubringen.

Im übrigen besteht die Möglichkeit, aus einer großen Zahl von Kombinationen von Polymerwerkstoffen auszuwählen, weil sich das Problem der Selektivität hinsichtlich der Metallisierung nicht mehr stellt. Es können insbesondere auch chemisch ähnliche oder weitgehend identische Polymerwerkstoffe - bei dem elektrisch leitfähigen Polymerwerkstoff natürlich in bezug auf die Matrix - ausgewählt werden, die hinsichtlich der Spritzgußverarbeitung unproblematisch sind und insbesondere gut aneinander haften. Besonders konsequent wird dieser Vorteil verwirklicht, wenn sich der erste und der zweite Polymerwerkstoff nur hinsichtlich des metallisch leitfähigen Füllstoffzusatzes und eventueller weiterer Zusätze unterscheiden, jedoch im Hinblick auf die jeweilige Matrix identisch sind.

Der Begriff des Mehrkomponentenspritzgießens umfaßt hier übrigens alle denkbaren Varianten. Insbesondere können die Komponenten nacheinander in ein und dieselbe Form gegossen werden, wobei diese Form in der Regel volumenveränderlich ist. Es kann jedoch auch ein Spritzgußteil aus einem ersten Spritzgußvorgang in eine andere Spritzgußform eingebracht werden, um den zweiten oder einen weiteren Werkstoff einzuspritzen. Schließlich ist es auch denkbar, gleichzeitig mit verschiedenen Werkstoffen zu spritzen, etwa indem eine Form an verschiedene Düsen angeschlossen wird. Diese Details sind Fragen der Spritzgußtechnik, die mit der Grundidee dieser Erfindung nicht in besonderer Beziehung stehen. Es wird auf den einschlägigen Stand der Technik zum Mehrkomponentenspritzguß verwiesen.

Der Spritzgußvorgang ist natürlich mit jeder zusätzlichen Komponente aufwendiger. Da sich mit einem elektrisch leitfähigen Polymerwerkstoff und einem weiteren isolierenden Polymerwerkstoff bei entsprechend geschickter Auslegung der geometrischen Strukturen schon eine außerordentlich große Vielfalt von Funktionen und Formen realisieren läßt, richtet sich die Erfindung bevorzugt auf die Verwendung von genau zwei Polymerwerkstoffen.

Denkbare weitere Füllstoffe neben dem erfindungsgemäß notwendigen metallisch leitfähigen Füllstoff für den elektrisch leitfähigen Polymerwerkstoff können z.B. Füllstoffe mit feldabhängigem elektrischen Widerstand sein, also mit sogenannten Varistor-Eigenschaften. Ein Beispiel hierfür sind Siliziumkarbid (SiC) und Zinkoxid (ZnO). Diese Materialien sind ohne äußeres elektrisches Feld isolierend, senken ihren spezifischen Widerstand jedoch mit zunehmendem elektrischen Feld. Dadurch lassen sich bestimmte Funktionen, etwa eine Feldbegrenzung, in dem Formteil integrieren. Der Varistor-Füllstoff kann dabei sowohl dem elektrisch leitfähigen als auch dem isolierenden Polymerwerkstoff zugesetzt werden.
Im Hinblick auf die angesprochenen Varistor-Eigenschaften ist im übrigen klarzustellen, daß sich die Angaben über die Leitfähigkeiten bzw. spezifischen Widerstände, wenn nicht anders festgestellt, immer auf einen feldfreien Zustand beziehen.

Bevorzugte Materialien für die Polymermatrix des elektrisch leitfähigen Polymermaterials sind die Polyolefine, etwa PE oder PP, ETFE, die Polyimide, PPS und PEEK.

Bevorzugte metallisch leitfähige Füllstoffe sind Silber (Ag), Zinn (Sn) und Blei (Pb) sowie Nickel (Ni), Metallkeramiken wie TiB₂, TiC, und außerdem Legierungen, insbesondere WCo-Legierungen.

Dabei ergibt sich beispielsweise aus PE mit Ni-Zusatz ein typischer PTC-Werkstoff. Mit diesem Begriff bezeichnet man Polymerwerkstoffe, die bei einer bestimmten Übergangstemperatur in der Umgebung der sog. Schmelztemperatur der Polymermatrix eine sprunghafte und drastische Erhöhung des spezifischen Ohmschen Widerstands zeigen. Solche Materialien sind also nur unterhalb der PTC-Übergangstemperatur als elektrisch leitfähig zu bezeichnen. In diesem Sinn bezieht sich der Begriff der elektrischen Leitfähigkeit in dieser Anmeldung, wenn nicht anders festgestellt, auf Raumtemperatur. Beispielsweise können Polymerwerkstoffe mit PE-Matrix schon im Bereich von 80°-130°C einen PTC-Übergang zeigen (die Schmelztemperatur liegt bei etwa 134°C). Die Verwendung von PE bietet sich also dann an, wenn der PTC-Übergang gewünscht ist. Dies kann erfindungsgemäß durchaus der Fall sein, nämlich wenn ein elektrisches Bauelement hergestellt werden soll, bei dem der PTC-Übergang zur Realisierung einer bestimmten elektrischen Funktion, etwa zur Strombegrenzung oder zur Stromunterbrechung eingesetzt wird. Dadurch kann ein integrierter PTC-Widerstand realisiert werden, der ebenfalls integriert kontaktiert werden kann. Zu den verschiedenen technischen Details von PTC-Polymermaterialien und ihren Anwendungsmöglichkeiten wird auf den einschlägigen Stand der Technik verwiesen.

Man kann allerdings auch mit einer PE-Matrix oder einer anderen relativ niedrigschmelzenden Polymermatrix arbeiten, ohne Gefahr zu laufen, daß das Formteil bei nicht allzu hohen Temperaturen einen PTC-Übergang zeigt. Dazu kann ein geeigneter Füllstoff Verwendung finden, mit dem das betreffende Polymermaterial keinen PTC-Übergang durchführt. Hierzu gehören weiche, duktile Materialien wie Ag, Sn und Pb, jedoch nicht Ni, die Metallkeramiken und die WCo-Legierungen. Außerdem spielt die Frage des PTC-Übergangs natürlich dann keine Rolle, wenn die Betriebstemperaturen des Formteils in seinem späteren Einsatz nicht in den relevanten Bereich gelangen.

Die Polymermaterialien ETFE, PPS und PEEK sowie die Polyimide zeigen (in dieser Reihenfolge ansteigende) Schmelztemperaturen in deutlich höheren Bereichen, nämlich von etwa 265°, 288°, 335° bzw. 388°C (für sog. Aurum als typisches Höchsttemperaturpolyimid). Dementsprechend hoch liegen die PTC-Übergangstemperaturen, die jedoch auch vom Füllstoff abhängen. PP nimmt eine Mittelstellung ein mit einer Schmelztemperatur von 175°C.

Zur Vermeidung eines PTC-Übergangs kann auch ein amorphes Polymermaterial Verwendung finden, jedoch haben diese Polymermaterialien in der Regel eine schlechtere Formstabilität als die klassischen Thermoplaste.

Bevorzugte Werte für den spezifischen Ohmschen Widerstand des metallisch leitfähigen Füllmaterials liegen bei 1mΩcm und darunter. Der Begriff der metallischen Leitfähigkeit ist in dieser Anmeldung auch nur im Hinblick auf die Leitfähigkeit zu verstehen: Neuartige oder exotische Materialien mit sehr guter elektrischer Leitfähigkeit (etwa die den Fullerenen nahestehenden sog. Nanotubes mit quantisierter Leitfähigkeit, die Kohlenstoffmodifikationen darstellen) werden ebenfalls als metallisch betrachtet. Eigentliche Metalle zeigen im übrigen häufig spezifische Widerstände im Bereich höchstens einiger µΩcm.

Der spezifische Ohmsche Widerstand des leitfähigen Polymerwerkstoffs, also der Mischung aus der Matrix und dem Füllstoff, sollte vorzugsweise höchstens 100 mΩcm betragen, vorzugsweise höchstens 50 mΩcm und im günstigsten Fall höchstens 10 mΩcm. Hierbei ist festzuhalten, daß die Kontaktwiderstände an einfachen Preßkontakten gemessen wurden. Durch Galvanisierung und/oder Steckverbindungen sollten sich hier wesentliche Verbesserungen erzielen lassen.
Die Isolationseigenschaften des isolierenden Polymerwerkstoffs sollten vorzugsweise über 10kΩcm, besser über 100kΩcm liegen.

Ein konkretes Beispiel für einen spezifischen Widerstand eines erfindungsgemäßen isolierenden Polymerwerkstoffs bildet SiC-gefülltes PE. Hier kommen spezifische Widerstände in der Größenordnung von 20-30 MΩcm zustande.

Die elektrischen Bauelemente, die mit den erfindungsgemäßen Formteilen hergestellt werden können, sind vorzugsweise Gehäuseteile oder Halterungen. Wenn sie eine elektrische Schaltung, einen Motor oder ein anderes zu kontaktierendes Bauteil tragen oder umgeben, können sie dazu Kontakte und Anschlußvorrichtungen aufweisen. Diese lassen sich in den erfindungsgemäßen elektrisch leitfähigen Polymerwerkstoffen beispielsweise gut als Steckkontakte ausbilden, wozu nicht notwendigerweise eine Metallisierung notwendig ist (vgl. Ausführungsbeispiele).

Eine Metallisierung kann natürlich vorteilhaft sein, um den Kontaktwiderstand noch zu optimieren oder um beispielsweise eine Lötung vornehmen zu können.

Eine solche Metallisierung könnte mit verschiedenen konventionellen Verfahren aufgebracht werden, im einfachsten Fall gepreßt werden. Von besonderem Interesse ist das erfindungsgemäße Verfahren jedoch im Hinblick auf eine Galvanisierung, weil sich durch den Unterschied der Leitfähigkeit zwischen den Polymerwerkstoffen eine selektive Galvanisierung anbietet. Die Galvanisierung von Polymerwerkstoffen ist an sich bekannt. Bei guter elektrischer Leitfähigkeit stellt sie auch bei elektrolytischen Verfahren kein Problem dar. Auch außenstromlose (sog. chemische) Verfahren können Verwendung finden, insbesondere wenn die Polymerwerkstoffoberfläche zuvor bekeimt wird, etwa mit Palladium (Pd).

### Kurze Beschreibung der Zeichnungen

Im folgenden wird die Erfindung anhand verschiedener Ausführungsbeispiele spezifischer erläutert, wobei die offenbarten Merkmale auch in anderen als den dargestellten Kombinationen erfindungswesentlich sein können.

Figur 1 zeigt dazu ein schematisiertes Beispiel für ein erfindungsgemäßes Bauelement, das Leiterbahnen in einer isolierenden Matrix aufweist;

Figur 2 zeigt ein weiteres Ausführungsbeispiel für ein erfindungsgemäßes Bauelement, bei dem ein PTC-Widerstandskörper in einer isolierenden Matrix eingebettet ist.

### Wege zur Ausführung der Erfindung

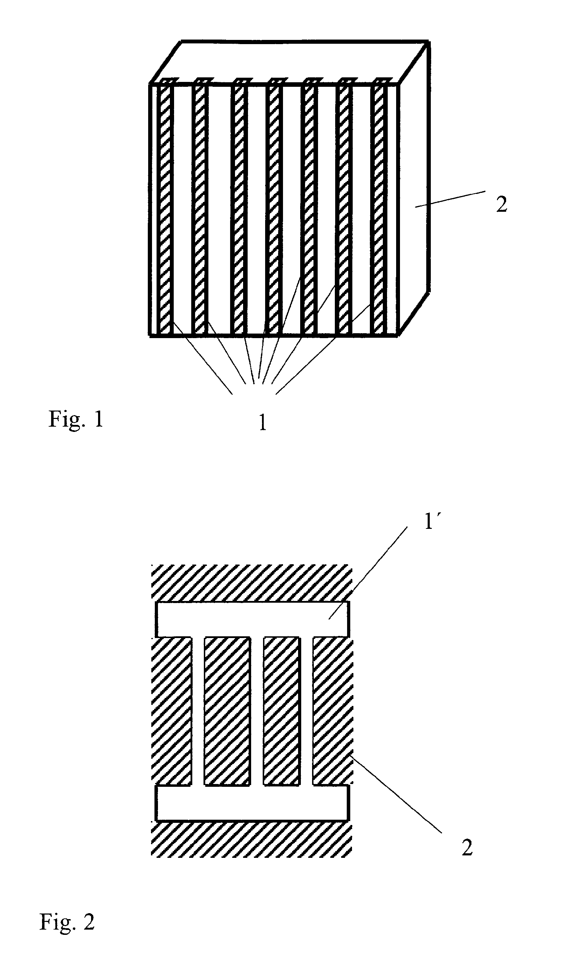

Figur 1 zeigt ein durch Zweikomponentenspritzguß hergestelltes elektrisches Bauelement, in dem Leiterbahnen 1 aus einem elektrischen leitfähigen Polymerwerkstoff in einer Matrix 2 aus einem isolierenden Polymerwerkstoff eingebettet sind. Bei dem elektrisch leitfähigen Polymerwerkstoff handelt es sich um PE mit einer Ag-Füllung (40 Vol%). Messungen ergaben einen spezifischen Widerstand dieses Materials von 0,28 mΩcm, wohingegen isolierendes PE (ohne Füllstoff) mit einem spezifischen Widerstand von 2 PΩcm oder mehr für die Matrix 2 verwendet wurde. Bei einer Querschnittsfläche von 4 mm² (z.B. 2 mm breit und 2 mm stark) ergeben sich dabei längenspezifische Ohmsche Widerstände von 7,0 mΩ/cm.

Figur 2 zeigt schematisiert eine Möglichkeit für die Integration einer weitergehenden elektrischen Funktion in einem erfindungsgemäßen Bauelement, das ebenfalls durch Zweikomponentenspritzguß hergestellt wird. In der ebenfalls mit 2 bezeichneten isolierenden PE-Matrix ist hier ein elektrisch leitfähiger Polymerwirkstoff 1' eingeschlossen, der aus einer PE-Matrix mit einer 40 Vol%-igen Füllung von TiB₂ besteht. Der spezifische Widerstand im leitfähigen Zustand liegt bei etwa 50 mΩcm, woraus sich bei einem Querschnitt von 9 mm² ein längenspezifischer Widerstandswert von 0,55 Ωcm ergibt. Dieses Bauelement kann als PTC-Widerstandselement dienen, es kann also in der an sich bekannten Weise der PTC-Effekt für elektrische Funktionen ausgenutzt werden.

Dabei kann die PE-Matrix 2 optional auch mit einem Varistor-Füllstoff wie SiC oder ZnO gefüllt sein. Die Kombination aus PTC-Elementen und Varistor-Elementen ist an sich Stand der Technik. Das in dem vorliegenden Beispiel durch die optional gefüllte PE-Matrix gebildete Varistor-Element dient dazu, ab bestimmten Spannungswerten bzw. Feldstärken im Material eine Überlastung des PTC-Elements 1' zu vermeiden, indem der Widerstand des parallel geschalteten Varistor-Materials sinkt und dieses damit die von den höchsten Feldstärken betroffenen Bereiche überbrückt (mit spezifischen Widerständen von in der Regel über 10 MΩ/cm).

Die relativ breiten Stege in den in Figur 2 oberen und unteren Bereichen des elektrischen Bauelements können zur Kontaktierung verwendet werden. Dazu sind sie, wie Figur 2 andeutet, seitlich offen ausgeführt, so daß die Zugänglichkeit zur Kontaktierung nicht durch die Matrix 2 behindert wird.

Weitere reale Meßwerte zu spezifischen Widerständen von erfindungsgemäß leitfähigen Polymerwerkstoffen liegen beispielsweise bei einer Mischung aus jeweils 50 Vol% TiB₂ und PE (Polyethylen) bei 10 mΩcm. Wegen der relativ niedrigen Temperatur des PTC-Übergangs kommt dieses Material zum einen für Anwendungen in Betracht, bei denen keine Temperaturen über 60-70°C zu erwarten sind, zum anderen allerdings auch für solche Anwendungen, in denen der PTC-Effekt als Funktionsmerkmal gewünscht ist.

Ersetzt man PE durch PPS, so verringert sich der spezifische Widerstand nicht nur auf 5 mΩcm, sondern es erhöht sich die PTC-Übergangstemperatur auch auf Werte von über 280°, so daß das PTC-Verhalten für gewöhnliche Anwendungen keine Rolle mehr spielt.

Noch bessere spezifische Widerstände können mit Ni als Füllstoff erzielt werden, nämlich 3 mΩcm in PE (50/50 Vol%) und 1 mΩcm in PPS. Für die PTC-Übergänge gelten im Prinzip die obigen Ausführungen.

Will man aus bestimmten Gründen mit PE arbeiten, jedoch das PTC-Verhalten ausschließen, so bietet sich außerdem die Möglichkeit, als Füllstoff Ag zu wählen. Vermutlich aufgrund der hohen Duktilität zeigt der Polymerwerkstoff dann keinen PTC-Übergang mehr. Typische Werte für den spezifischen Widerstand liegen bei einem Mischungsverhältnis von 35/65 Vol% Ag/PE bei 0,6 mΩcm und bei einem Mischungsverhältnis von 40/60 Vol% wie erwähnt sogar bei 0,28 mΩcm.
Vergleicht man diese Werte mit einem besonders guten metallischen Leiter, nämlich metallischem Cu mit 2 µΩcm, so erkennt man, daß die erfindungsgemäßen elektrisch leitfähigen Polymerwerkstoffe etwa um einen Faktor 140 höhere spezifische Widerstände zeigen. Da jedoch bei dem erfindungsgemäßen Verfahren die Leitungsfunktionen von dem Volumenmaterial des Formteils ausgefüllt werden, erhöhen sich die Stärken der Leiterbahnen gegenüber klassischen Metallisierungen ebenfalls. Wenn man also eine sehr gute elektrolytische Metallisierung von 30µm betrachtet, so kommt man bei gleichem Ohmschen Widerstand auf eine notwendige Materialstärke des elektrisch leitfähigen Polymerwerkstoffs in der Größenordnung von 4,5 mm. Zudem können erfindungsgemäße Leiterbahnen verbreitert sein. Man erkennt, daß sich aufgrund der Stromleitung im Volumen ohne weiteres auch mit der Erfindung Ohmsche Widerstände im Bereich der konventionellen technischen Lösungen erzielen lassen. Im übrigen spielt der Ohmsche Widerstand einer solchen Leiterbahn bei vielen Anwendungen keine wesentliche Rolle.

Typische Kontaktwiderstände bei einfachen gepreßten Kontakten lagen bei Untersuchungen des Erfinders in der Größenordnung einiger 10 mΩ (z.B. 30 mΩ pro Kontakt auf Ag/PE mit 40/60 Vol% oder 90 mΩ pro Kontakt auf TiB₂/PPS mit 50/50 Vol%). Diese Kontaktwiderstände liegen in der Größenordnung der bei konventionellen metallischen Leiterbahnen auftretenden Bahnwiderstände. Beispielsweise hat eine 30 µm dicke, 1 mm breite und 30 mm lange Cu-Leiterbahn einen Widerstand von etwa 20 mΩ.

## Patentansprüche

1. Verfahren zur Herstellung von Formteilen, die eine elektrische Leitungsfunktion aufweisen,
bei dem das Formteil mit zumindest zwei Polymerwerkstoffen (1, 1', 2) spritzgegossen wird,
**dadurch gekennzeichnet, daß** zumindest einer der Polymerwerkstoffe (1, 1') eine Polymermatrix und einen metallisch leitfähigen Füllstoff aufweist und durch diesen elektrisch leitfähig ist und
zumindest ein weiterer der Polymerwerkstoffe (2) elektrisch isolierend ist.

2. Verfahren nach Anspruch 1, bei dem das Formteil aus genau zwei Polymerwerkstoffen (1, 1', 2) spritzgegossen wird.

3. Verfahren nach Anspruch 1 oder 2, bei dem die Polymermatrix des elektrisch leitfähigen Polymerwerkstoffs (1, 1') und zumindest ein weiterer Polymerwerkstoff (2) im wesentlichen aus demselben Polymertyp bestehen.

4. Verfahren nach einem der vorstehenden Ansprüche, bei dem zumindest ein von dem elektrisch leitfähigen Polymerwerkstoff (1, 1') verschiedener Polymerwerkstoff eine Polymermatrix und einen Füllstoff mit Varistor-Eigenschaften aufweist.

5. Verfahren nach einem der vorstehenden Ansprüche, bei dem die Polymermatrix des elektrisch leitfähigen Polymerwerkstoffs (1, 1') im wesentlichen aus einem Material aus der Gruppe aus den Polyolefinen, ETFE, den Polyimiden, PPS und PEEK besteht.

6. Verfahren nach einem der Ansprüche 1 bis 4, bei dem die Polymermatrix des elektrisch leitfähigen Polymerwerkstoffs (1, 1') im wesentlichen aus einem amorphen Polymer besteht.

7. Verfahren nach einem der vorstehenden Ansprüche, bei dem der metallisch leitfähige Füllstoff im wesentlichen aus einem Metall aus der Gruppe aus Ag, Sn, Pb, Ni, TiB₂, TiC, oder aus einer WCo-Legierung besteht.

8. Verfahren nach Anspruch 4, auch in Verbindung mit einem weiteren der vorstehenden Ansprüche, bei dem der Füllstoff mit Varistor-Eigenschaften im wesentlichen aus SiC oder ZnO besteht.

9. Verfahren nach einem der vorstehenden Ansprüche, bei dem der metallisch leitfähige Füllstoff einen spezifischen Widerstand von höchstens 1mΩcm aufweist.

10. Verfahren nach einem der vorstehenden Ansprüche, bei dem das elektrisch leitfähige Polymermaterial (1, 1') einen spezifischen Widerstand von höchstens 100 mΩcm aufweist.

11. Verfahren nach einem der vorstehenden Ansprüche, bei dem der elektrisch isolierende Polymerwerkstoff (2) einen spezifischen Widerstand von zumindest 10 kΩcm aufweist.

12. Elektrisches Bauelement, das nach einem Verfahren nach einem der vorstehenden Ansprüche hergestellt wurde.

13. Elektrisches Bauelement nach Anspruch 12, das eine auf dem elektrisch leitfähigen Polymerwerkstoff (1, 1') aufgebrachte Metallisierung aufweist.

14. Elektrisches Bauelement nach Anspruch 13, bei dem die Metallisierung galvanisiert ist.

15. Elektrisches Bauelement nach einem der vorstehenden Ansprüche, das einen in dem elektrisch leitfähigen Polymerwerkstoff (1, 1') ausgeführten Steckkontakt aufweist.

16. Verwendung eines elektrischen Bauelements nach einem der Ansprüche 12 bis 15, bei der der elektrisch leitfähige Polymerwerkstoff (1') einen PTC-Übergang zeigt.

17. Verwendung nach Anspruch 16, bei der eine durch den elektrisch leitfähigen Polymerwerkstoff (1') gebildete Leitungsbahn eine Strombegrenzungsoder -unterbrechungsfunktion hat.
